(19) Europäisches Patentamt / European Patent Office / Office européen des brevets

(11) **EP 3 376 515 B1**

(12) **FASCICULE DE BREVET EUROPEEN**

(45) Date de publication et mention de la délivrance du brevet:
**26.05.2021 Bulletin 2021/21**

(51) Int Cl.:
**H01H 1/00** *(2006.01)* **H01P 1/12** *(2006.01)*
**H03K 17/18** *(2006.01)*

(21) Numéro de dépôt: **18160737.5**

(22) Date de dépôt: **08.03.2018**

(54) **DISPOSITIF DE COMMUTATION HYPERFRÉQUENCE AVEC LECTURE PAR TÉLÉMESURE DE L'ÉTAT DES CONNECTIONS DES ENTRÉES ET SORTIES**

HYPERFREQUENZ-SCHALTVORRICHTUNG MIT ABLESUNG DURCH FERNMESSUNG DES ZUSTANDS DER EINGANGS- UND AUSGANGSANSCHLÜSSE

MICROWAVE SWITCHING DEVICE WITH READING BY TELEMETRY OF THE STATE OF THE INPUT AND OUTPUT CONNECTIONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.03.2017 FR 1700276**

(43) Date de publication de la demande:
**19.09.2018 Bulletin 2018/38**

(73) Titulaire: **THALES**
**92400 Courbevoie (FR)**

(72) Inventeurs:
• **VENDIER, Olivier**
**31320 Aureville (FR)**
• **RODRIGUEZ, Raoul**
**31150 Bruguieres (FR)**
• **CHABAUD, Pierre-Yves**
**31500 Toulouse (FR)**
• **POTUAUD, Dominique**
**31880 La Salvetat Saint Gilles (FR)**
• **BATTUT, Jérôme**
**31000 Toulouse (FR)**
• **BORNET, Johann**
**31520 Ramonville Saint Agne (FR)**

• **ADAM, Thierry**
**31170 Tournefeuille (FR)**
• **VILLEMAZET, Jean-François**
**31550 Cintegabelle (FR)**
• **GROJEAN, François**
**31120 Portet Sur Garonne (FR)**

(74) Mandataire: **Marks & Clerk France**
**Immeuble "Visium"**
**22, avenue Aristide Briand**
**94117 Arcueil Cedex (FR)**

(56) Documents cités:
**US-A1- 2004 095 205    US-A1- 2004 263 297**

• **CHIRAG D PATEL ET AL: "A High-Reliability High-Linearity High-Power RF MEMS Metal-Contact Switch for DC 40-GHz Applications", IEEE TRANSACTIONS ON MICROWAVE THEORY AND TECHNIQUES, PLENUM, USA, vol. 60, no. 10, 1 octobre 2012 (2012-10-01), pages 3096-3112, XP011465683, ISSN: 0018-9480, DOI: 10.1109/TMTT.2012.2211888**

EP 3 376 515 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

L'invention se situe dans le domaine des équipements destinés à être embarqués à bord de satellites, plus précisément les équipements hyperfréquences configurés en assemblage comme les chaînes de conversion de fréquence en lien avec les charges utiles.

Les spécifications en termes de débit de données des nouveaux satellites de télécommunication impliquent la présence d'un grand nombre d'équipements hyperfréquences, comme les chaînes de conversion) qui doivent souvent être redondées pour tenir les spécifications de fiabilité.

La centralisation de la redondance au niveau d'un satellite pose des difficultés techniques qui peuvent limiter la complexité de la charge utile, augmenter son coût, ou encore diminuer sa fiabilité en supprimant ou simplifiant la redondance.

Les assemblages, ou "assemblies" en langue anglaise, de chaînes de conversion de fréquence ou autres équipements hyperfréquences sont actuellement réalisés en technologie hybride, avec une redondance centralisée au niveau du satellite.

On entend par technologie hybride, un élément comprenant un ou plusieurs substrats isolés, généralement en céramique, sur lesquels des composants actifs et passifs sont interconnectés dans le but de réaliser une fonction électrique; les composants actifs pouvant être des puces nues ou des composants en boîtier, les composants passifs pouvant être imprimés sur le substrat ou être des composants à coller et câbler. Dans tous les cas, le report des composants se fait par collage et câblage microélectronique contrairement à la technologie carte qui utilise des composants à montage en surface, assemblés par brasage sur circuit imprimé.

Pour ce type d'équipement, les anneaux de redondance sont réalisés avec des commutateurs, ou "switches" en langue anglaise, coaxiaux (en général de type T) interconnectés par un harnais radiofréquence ou RF (câble & connecteurs coaxiaux) et un harnais à courant continu ou DC pour acronyme de "direct current" en langue anglaise.

Ces solutions existantes utilisent des commutateurs coaxiaux ayant un coût (> 4k€ par commutateur) et une masse élevés, même lorsqu'ils sont intégrés sous forme d'assemblage. En outre, le coût d'intégration de chaque commutateur sur la charge utile est élevé.

De tels dispositifs de commutation hyperfréquence de l'état de l'art sont divulgués dans le document US 2004/095205 et le document "A High-Reliability High-Linearity High-Power RF MEMS Metal-Contact Switch for OC 40-GHz Applications" de CHIRAG D PATEL ET AL, IEEE TRANSACTIONS ON MICROWAVE THEORY AND TECHNIQUES, PLENUM, USA, vol. 60, no. 10, 1 octobre 2012 (201 2-10-01 ), pages 3096-31 12, XP01 1465683, ISSN: 0018-9480, DOI: 1 O. 11 09/TMTT.201 2.2211888.

Un but de l'invention est de pallier les problèmes précédemment cités, et plus particulièrement de limiter les coûts des commutateurs embarqués à bord de satellites ainsi que le coût d'assemblage, d'intégration et de test des anneaux de redondance.

Aussi, il est proposé, selon un aspect de l'invention, un dispositif de commutation hyperfréquence comprenant:

- une matrice de commutation à M entrées et N sorties comprenant au moins un commutateur hyperfréquence à contacts ohmiques montable en surface à au moins une entrée et au moins une position de sortie, apte à réaliser au moins une commutations entre au moins une des M entrées et au moins une des N sorties de la matrice de commutation ;
- un bus de commande du ou des commutateurs hyperfréquence de la matrice de commutation ;
- un T de polarisation disposé sur chaque entrée de la matrice de commutation ;
- un T de polarisation disposé sur chaque sortie de la matrice de commutation;
- un bus de télécommande des M entrées configuré pour commander chaque tension électrique, appliquée entre une masse et une entrée DC de chaque T de polarisation disposé sur chaque entrée de la matrice de commutation; et
- un bus de télémesure des N sorties configuré pour mesurer chaque tension électrique, appliquée entre la masse et une sortie DC de chaque T de polarisation disposé sur chaque sortie de la matrice de commutation, le dispositif étant configuré pour déterminer l'état de chaque commutateur hyperfréquence à partir desdites mesures de tension électrique, appliquée entre la masse et une sortie DC de chaque T de polarisation disposé sur chaque sortie ($S_1$, $S_2$, ...$S_N$).

Un tel dispositif permet d'utiliser des composants montables en surface, développés pour des technologies au sol, pour des satellites et ainsi baisser les coûts associés, en permettant une télémesure de l'état du commutateur, qui n'est pas prévue pour les technologies au sol.

Selon un mode de réalisation, le ou les commutateurs hyperfréquence à contacts ohmiques montables en surface à au moins une entrée et au moins une position de sortie sont électromécaniques bistables.

Ainsi, cette configuration permet de superposer au signal hyperfréquence en entrée un signal DC (courant continu) et ainsi connaitre par mesure simple de la tension DC en sortie, l'état de chaque commutateur hyperfréquence, ce qui n'est pas possible quand les contacts sont par exemple capacitifs.

Dans un mode de réalisation, au moins un T de polarisation comprend un condensateur et une bobine d'inductance.

Selon un mode de réalisation, au moins un T de polarisation comprend deux condensateurs et une bobine d'inductance.

Dans un mode de réalisation, un condensateur de T de polarisation peut être remplacé par une ligne couplée.

Selon un mode de réalisation, une bobine d'inductance de T de polarisation peut être remplacée par une ligne quart d'onde.

Selon un mode de réalisation:

- la matrice de commutation comprend un seul commutateur hyperfréquence à contacts ohmiques à une entrée et deux positions de sortie ou deux commutateurs hyperfréquence à contacts ohmiques à une entrée et une position de sortie, montables en surface;
- le T de polarisation disposé sur l'entrée de la matrice de polarisation comprend un circuit LC d'entrée, comprenant une bobine d'inductance d'entrée et un condensateur d'entrée, et connecté entre la bobine d'inductance d'entrée et le condensateur d'entrée à l'entrée du commutateur, la tension électrique en sortie de la bobine d'inductance d'entrée étant représentative de l'état du commutateur;
- le T de polarisation disposé sur la première sortie de la matrice de polarisation comprend un premier circuit LC de sortie, comprenant une première bobine d'inductance de sortie et un premier condensateur de sortie, connecté, entre la première bobine d'inductance de sortie et le premier condensateur de sortie, à la première position de sortie du commutateur, et dont la première bobine d'inductance de sortie est connectée, en son extrémité non reliée au premier condensateur de sortie, à une première référence de tension électrique;
- le T de polarisation disposé sur la deuxième sortie de la matrice de polarisation comprend un deuxième circuit LC de sortie, comprenant une deuxième bobine d'inductance de sortie et un deuxième condensateur de sortie, connecté, entre la deuxième bobine d'inductance de sortie et le deuxième condensateur de sortie, à la deuxième position de sortie du ou des commutateurs hyperfréquence, et dont la deuxième bobine d'inductance de sortie est connectée, en son extrémité non reliée au deuxième condensateur de sortie, à une deuxième référence de tension électrique;
- le bus de commande du commutateur hyperfréquence de la matrice de commutation le circuit de commande de commutation comprend une première partie comprenant une première bobine d'inductance de commande disposée à proximité de la première position de sortie, et une deuxième partie comprenant une deuxième bobine d'inductance de commande disposée à proximité de la deuxième position de sortie, la première partie comprenant une première diode de commande disposée en parallèle de la première bobine d'inductance (L1) formant un ensemble connecté d'un côté à une référence de tension électrique de commande et connecté de l'autre côté à un premier interrupteur relié à la masse, et la deuxième partie comprenant une deuxième diode de commande disposée en parallèle de la deuxième bobine d'inductance formant un ensemble connecté d'un côté à la référence de tension électrique de commande et connecté de l'autre côté à un deuxième interrupteur relié à la masse;

les capacités du condensateur d'entrée, du premier condensateur de sortie et du deuxième condensateur de sortie étant identiques; et les inductances de la bobine d'inductance d'entrée, de la première bobine d'inductance de sortie et de la deuxième bobine d'inductance de sortie étant identiques.

Dans un mode de réalisation, le ou les commutateurs hyperfréquences de la matrice de commutation sont à commande impulsionnelle.

Il est également proposé, selon un autre aspect de l'invention, un dispositif de conversion de fréquences pour satellites comprenant un râtelier ou "rack" en langue anglaise, et au moins une carte électronique adaptée pour être disposée dans le râtelier, la carte électronique comprenant au moins un dispositif de commutation selon l'une des revendications précédentes.

L'invention sera mieux comprise à l'étude de quelques modes de réalisation décrits à titre d'exemples nullement limitatifs et illustrés par les dessins annexés sur lesquels :

- la figure 1 illustre schématiquement un dispositif de commutation hyperfréquence, selon un aspect de l'invention,
- la figure 2 illustre un T de polarisation, selon un aspect de l'invention,
- les figures 3 à 6 illustrent schématiquement des modes de réalisation de T de polarisation,
- la figure 7 illustre schématiquement une matrice de commutation à une entrée et deux sorties,
- la figure 8 représente schématiquement un exemple de matrice de commutation à 4 entrées et 5 sorties,
- la figure 9 représente schématiquement un exemple de matrice de commutation à 6 entrées et 8 sorties,
- la figure 10 illustre un râtelier comprenant au moins une carte électronique muni d'au moins un dispositif de commutation hyperfréquence, selon un aspect de l'invention.

Sur les différentes figures, les éléments ayant des références identiques sont identiques.

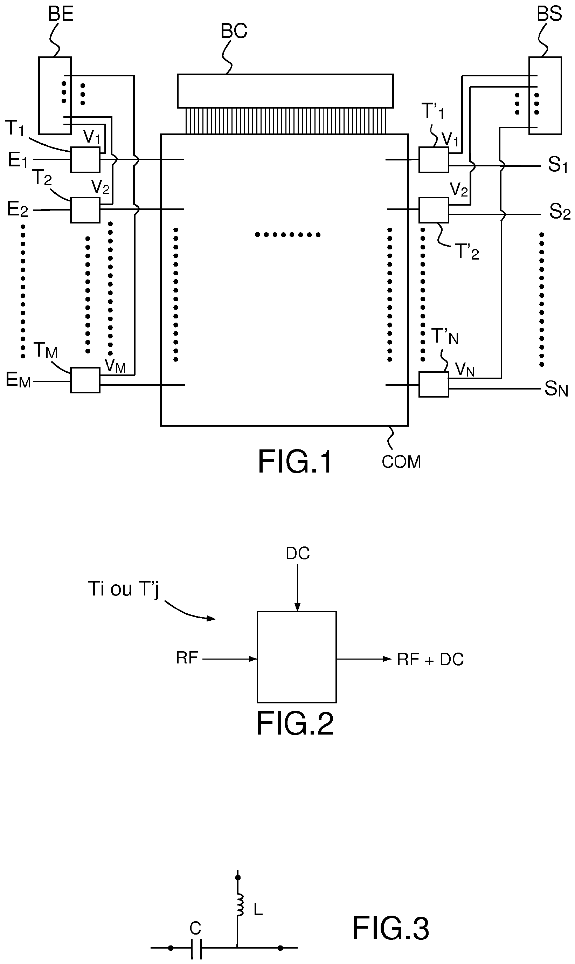

La figure 1 représente un dispositif de commutation hyperfréquence comprenant:

- une matrice de commutation COM à M entrées $E_1$, $E_2$, ... $E_M$ et N sorties $S_1$, $S_2$, ...$S_N$ comprenant au moins un commutateur hyperfréquence à contacts ohmiques, par exemple électromécanique bistable, montable en surface à au moins une entrée et au moins une position de sortie;

- un bus de commande BC du ou des commutateurs hyperfréquencede la matrice de commutation COM;
- un bus BE de télécommande des M entrées $E_1$, $E_2$, ... $E_M$;
- un bus BS de télémesure des N sorties $S_1$, $S_2$, ...$S_N$;
- un T de polarisation $T_1$, $T_2$, ... $T_M$ disposé sur chaque entrée $E_1$, $E_2$, ... $E_M$ de la matrice de commutation COM; et
- un T de polarisation $T'_1$, $T'_2$, ... $T'_s$ disposé sur chaque sortie $S_1$, $S_2$, ...$S_N$ de la matrice de commutation COM.

Concernant un T de polarisation $T_2$, ... $T_M$ disposé sur une entrée respective $E_1$, $E_2$, ... $E_M$ de la matrice de commutation COM, la sortie RF+DC est connectée à l'entrée correspondante de la matrice de commutation COM, l'entrée RF reçoit le signal à destination de l'entrée correspondante de la matrice de commutation COM, et l'entrée DC est connectée au bus BE de télémesure des M entrées $E_1$, $E_2$, ... $E_M$ permettant de commander la tension électrique $VT_i$ appliquée entre la masse et l'entrée DC du T de polarisation $T_2$, ... $T_M$ dans la matrice de commutation sans affecter les performances hyperfréquences de la matrice de commutation COM.

Concernant un T de polarisation $T'_1$, $T'_2$, ... $T'_M$ disposé sur une sortie respective $S_1$, $S_2$, ...$S_N$ de la matrice de commutation COM, l'entrée RF+DC est connectée à la sortie correspondante de la matrice de commutation COM, la sortie RF du T de polarisation transmet le signal venant de l'entrée correspondante de la matrice de commutation COM, et la sortie DC est connectée au bus BS de télémesure des N sorties $S_1$, $S_2$, ... $S_N$ permettant de mesurer la tension $VT_j$ lue entre la masse et la sortie DC du T de polarisation $T'_1$, $T'_2$, ... $T'_M$ dans la matrice de commutation sans affecter les performances hyperfréquences de la matrice de commutation COM.

Et ainsi de suite sur les M entrées et N sorties, avec ce principe, on relève les $VT_j$ (j variant de 1 à N) et on sait ainsi à quelles entrées les N sorties sont reliées à partir des tensions $VT_i$ (i variant de 1 à M) appliquées. Ainsi si $VT_i$ est égal $VT_j$, l'entrée i est reliée à la sortie j.

La figure 2 représente schématiquement un T de polarisation, recevant en entrée une voie RF et une voie DC, et délivrant en sortie RF+DC. Ce composant permet de superposer à un signal RF un signal DC dans sa configuration en entrée de la matrice COM, ou une fonction duale quand il est utilisé en sortie de la matrice COM.

Les figures 3 à 6 représentent divers modes de réalisation d'un T de polarisation.

La figure 3 représente un T de polarisation comprenant un condensateur C et une bobine d'inductance L.

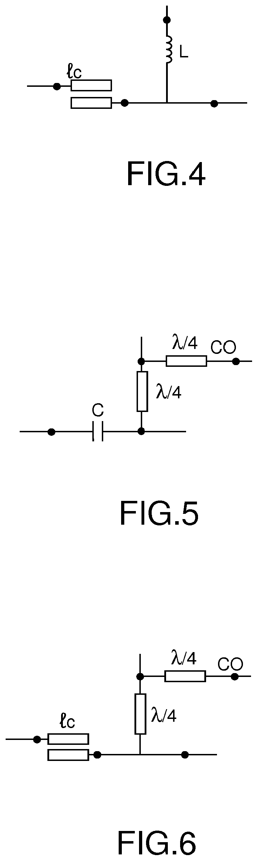

La figure 4 représente un T de polarisation comprenant une ligne couplée lc et une bobine d'inductance L.

La figure 5 représente un T de polarisation comprenant un condensateur C et deux lignes quart d'onde $^\lambda/_4$ en série, dont celle à l'extrémité est en circuit ouvert CO

La figure 6 représente un T de polarisation comprenant une ligne couplée lc et deux lignes quart d'onde $^\lambda/_4$ en série, dont celle à l'extrémité est en circuit ouvert CO.

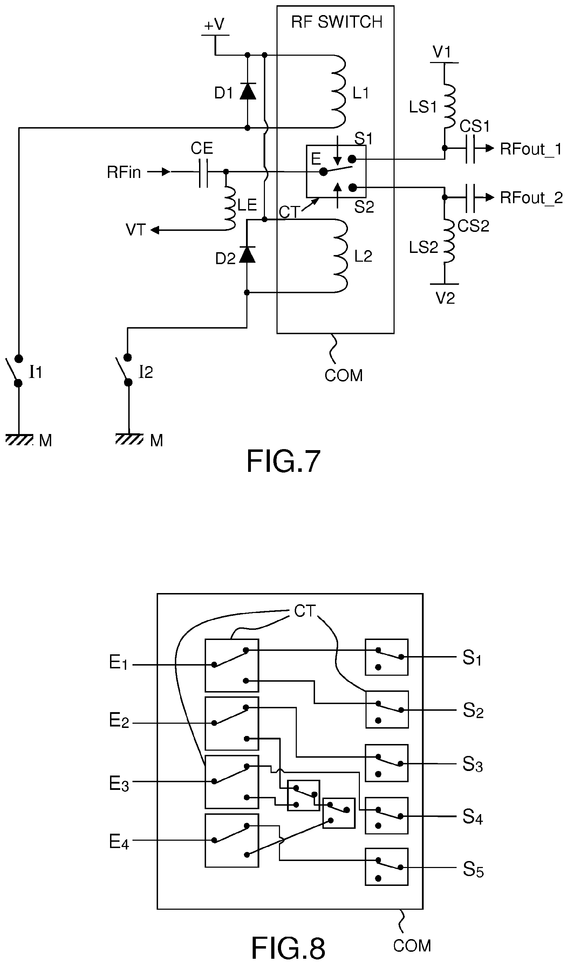

La figure 7 représente un dispositif de commutation selon un aspect de l'invention, dans lequel

- la matrice de commutation COM comprend un seul commutateur hyperfréquence CT à contacts ohmiques, par exemple électromécanique bistable, à deux positions de sortie, montable en surface;
- le T de polarisation disposé sur l'entrée de la matrice de polarisation comprend un circuit LC d'entrée, comprenant une bobine d'inductance d'entrée LE et un condensateur d'entrée CE, et connecté entre la bobine d'inductance d'entrée LE et le condensateur d'entrée CE à l'entrée E du commutateur hyperfréquence CT, la tension électrique VT en sortie de la bobine d'inductance d'entrée LE étant représentative de l'état du commutateur COM;
- le T de polarisation disposé sur la première sortie de la matrice de polarisation comprend un premier circuit LC de sortie, comprenant une première bobine d'inductance de sortie LS1 et un premier condensateur de sortie CS1, connecté, entre la première bobine d'inductance de sortie LS1 et le premier condensateur de sortie CS1, à la première position de sortie S1 du commutateur hyperfréquence CT, et dont la première bobine d'inductance de sortie LS1 est connectée, en son extrémité non reliée au premier condensateur de sortie CS1, à une première référence V1 de tension électrique;
- le T de polarisation disposé sur la deuxième sortie de la matrice de polarisation comprend un deuxième circuit LC de sortie, comprenant une deuxième bobine d'inductance de sortie LS2 et un deuxième condensateur de sortie CS2, connecté, entre la deuxième bobine d'inductance de sortie LS2 et le deuxième condensateur de sortie CS2, à la deuxième position de sortie S2 du commutateur hyperfréquence CT, et dont la deuxième bobine d'inductance de sortie LS2 est connectée, en son extrémité non reliée au deuxième condensateur de sortie CS2, à une deuxième référence V2 de tension électrique;
- le bus de commande BC du commutateur hyperfréquence CT de la matrice de commutation COM une première partie comprenant une première bobine d'inductance de commande L1 disposée à proximité de la première position de sortie S1, et une deuxième partie comprenant une deuxième bobine d'inductance de commande L2 disposée à proximité de la deuxième position de sortie S2, la première partie comprenant une première diode de commande D1 disposée en parallèle de la première bobine d'inductance L1 formant un ensemble connecté d'un côté à une référence V de tension électrique de commande et connecté de l'autre côté à un premier interrupteur I1 relié à la masse M, et la deuxième partie comprenant une deuxième diode de commande D2 disposée en parallèle de la deuxième bobine d'inductance L2 formant un ensemble connecté d'un côté à la référence V de tension électrique de commande et connecté de l'autre côté à un deuxième interrupteur I2 relié à la masse M;

les capacités du condensateur d'entrée CE, du premier condensateur de sortie CS1 et du deuxième condensateur de sortie CS2 étant identiques; et les inductances de la bobine d'inductance d'entrée LE, de la première bobine d'inductance de sortie LS1 et de la deuxième bobine d'inductance de sortie LS2 étant identiques.

En variante, la matrice de commutation COM peut comprendre deux commutateurs hyperfréquence CT à contacts ohmiques à une entrée et une position de sortie, par exemple électromécanique bistable, montables en surface.

Le bus de commande BC du commutateur hyperfréquence CT de la matrice de commutation COM comprend une première partie comprenant une première bobine d'inductance de commande L1 disposée à proximité de la première position de sortie S1, et une deuxième partie comprenant une deuxième bobine d'inductance de commande L2 disposée à proximité de la deuxième position de sortie S2.

La première partie comprend une première diode de commande D1 disposée en parallèle de la première bobine d'inductance L1 formant un ensemble connecté d'un côté à une référence V de tension électrique de commande et connecté de l'autre côté à un premier interrupteur I1 relié à la masse M.

La deuxième partie comprend une deuxième diode de commande D2 disposée en parallèle de la deuxième bobine d'inductance L2 formant un ensemble connecté d'un côté à la référence V de tension électrique de commande et connecté de l'autre côté à un deuxième interrupteur I2 relié à la masse M.

Les bobines d'inductance sont préférentiellement des bobines à commande impulsionnelle pour minimiser la consommation électrique du dispositif de commutation, mais peuvent être des bobines statiques.

Les commutateurs hyperfréquence utilisés, de technologie montable en surface, ou CMS pour acronyme de Composant Monté en Surface, permet de limiter les coûts comparés aux commutateurs électromécaniques spécifiques utilisés actuellement.

La tension électrique V nécessaire pour commuter le commutateur hyperfréquence CT peut être de 12V, et les première et deuxième diodes de commande D1 et D2 dites diodes de roue libre, ou tout autre dispositif permettant de limiter la tension transitoire apparaissant aux bornes de la bobine L1 et L2 à la fermeture des interrupteurs I1 ou I2.

Lorsque le deuxième interrupteur I2 est fermé, la deuxième bobine d'inductance L2 est polarisée à la référence V de tension électrique de commande, ce qui entraîne la commutation du commutateur hyperfréquence CT en deuxième position de sortie S2, et la tension de sortie RFout_2 du dispositif de commutation est alors égale à la tension d'entrée RFin.

Lorsque le premier interrupteur I1 est fermé, la première bobine d'inductance L1 est polarisée à la référence V de tension électrique de commande, ce qui entraîne la commutation du commutateur hyperfréquence CT en première position de sortie S1, et la tension de sortie RFout_1 du dispositif de commutation est alors égale à la tension d'entrée RFin.

La tension électrique VTm en sortie de la bobine d'inductance d'entrée LE est un signal de télémesure représentatif de l'état du commutateur hyperfréquence CT.

Lorsque le commutateur CT est en première position de sortie S1, la tension électrique $VTm_1$ est égale à la première référence V1 de tension électrique, qui est supérieure ou égale à la tension VIH de seuil correspondant au niveau logique haut. Par exemple V1 = 2.5 V si VIH = 2 V.

Lorsque le commutateur hyperfréquence CT est en deuxième position de sortie S2, la tension électrique $VTm_1$ est égale à la deuxième référence V2 de tension électrique, qui est inférieure ou égale à la tension VIL de seuil correspondant au niveau logique bas. Par exemple V2 = 0.5V si VIL = 0,8 V.

Les bobine d'inductances d'entrée LE, de première sortie LS1 et de deuxième sortie LS2, de valeur identique, empêchent de coupler le signal RF sur les tensions continues de référence V1, et V2 et de sortie de l'inductance d'entrée VT.

Les condensateurs d'entrée CE, de première sortie C1 et de deuxième sortie C2, de valeur identique, empêchent de superposer un signal continu sur les lignes hyperfréquences d'entrée RFin et de sorties RFout_1 et RFout_2.

Les capacités CE, CS1, CS2 ont des valeurs identiques et les inductances LE, L1 et L2 ont des valeurs identiques, qui dépendent de la fréquence f et de sa largeur de bande delta f. La fréquence f est la fréquence d'utilisation de matrice de commutation COM.

Tout d'abord, ces valeurs sont déterminées pour une configuration de ligne de transmission, ayant une impédance caractéristique de ligne Z0. Par convention cette valeur est en générale fixée à 50 Ohms.

L'impédance Xc de la capacité et XL de l'inductance sont choisies respectivement de faibles valeurs et de forte valeur par rapport à l'inductance caractéristique de ligne Z0. Elles vérifient les équations ci-dessous où w est la pulsation en rad/s et f la fréquence d'utilisation en Hertz.

Dans cette approche, on a supposé que la capacité et l'inductance étaient idéales et donc sans éléments parasites.

$$X_C = \frac{1}{\omega C} = \frac{1}{2\pi f C} \ll Z_0,$$

$$X_L = \omega L = 2\pi f L \gg Z_0,$$

Sur les figures de la présente demande, les exemples représentés de matrice de commutation COM, le sont avec des commutateurs hyperfréquence CT à une entrée et deux positions de sortie, car ce sont les plus courants, mais bien entendu, en variante, la matrice de commutation COM peut être réalisée de nombreuses manières différentes avec les commutateurs hyperfréquence CT différents en termes de nombre d'entrées et de nombre de sorties.

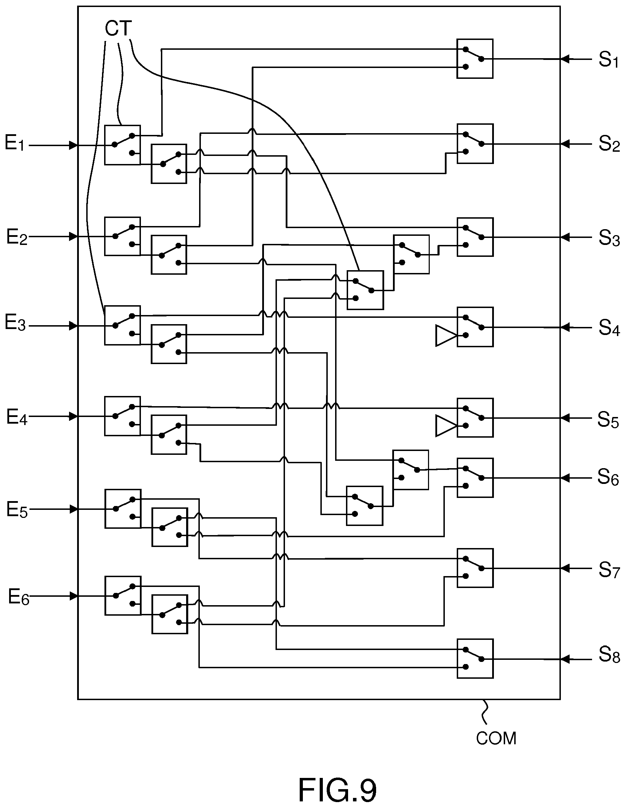

La figure 8 représente schématiquement un exemple de matrice de commutation à 4 entrées et 5 sorties, et la figure 9 représente schématiquement un exemple de matrice de commutation COM à 6 entrées et 8 sorties.

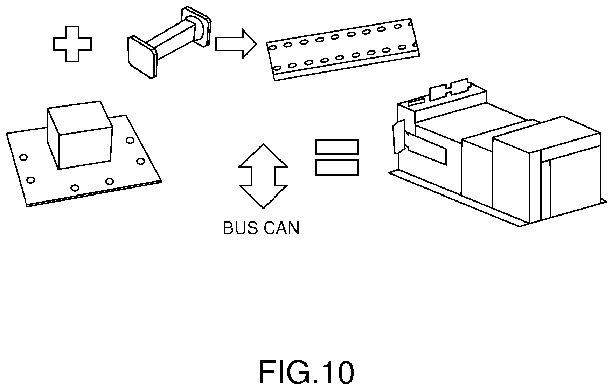

La figure 10 représente schématiquement sur la partie gauche, le commutateur hyperfréquence CT montable en surface sur carte électronique et électromécanique bistable, un guide d'onde normalement réalisé en technologie classique par usinage de barre métallique qui est implémenté dans l'invention en guide d'onde intégré à la carte électronique ceci permettant de réaliser la matrice de commutation en connectant les commutateur hyperfréquence CT. Ainsi, qui, au moyen de l'utilisation de dispositifs de commutation selon l'invention permettent de réaliser un méta-équipement, représenté sur la partie droite sous forme d'un râtelier (RACK) ou rack comprenant au moins une carte électronique adaptée pour être disposée dans le râtelier, la carte électronique comprenant au moins un dispositif de commutation selon l'invention, et les guides d'ondes intégrés à la carte électronique.

**Revendications**

1. Dispositif de commutation hyperfréquence comprenant:

    - une matrice de commutation (COM) à M entrées ($E_1$, $E_2$, ... $E_M$) et N sorties ($S_1$, $S_2$, ...$S_N$) comprenant au moins un commutateur hyperfréquence (CT) à contacts ohmiques montable en surface à au moins une entrée et au moins une position de sortie, apte à réaliser au moins une commutation entre au moins une des M entrées et au moins une des N sorties de la matrice de commutation (COM) ;
    - un bus de commande (BC) du ou des commutateurs hyperfréquence (CT) de la matrice de commutation (COM);

    - un T de polarisation ($T_1$, $T_2$, ... $T_M$) disposé sur chaque entrée ($E_1$, $E_2$, ... $E_M$) de la matrice de commutation (COM);
    - un T de polarisation ($T'_1$, $T'_2$, ... $T'_S$) disposé sur chaque sortie de la matrice de commutation;
    - un bus de télécommande (BE) des M entrées ($E_1$, $E_2$, ... $E_M$) configuré pour commander chaque tension électrique ($VT_i$, $i \in [\![1; M]\!]$), appliquée entre une masse et une entrée DC de chaque T de polarisation ($T_1$, $T_2$, ... $T_M$) disposé sur chaque entrée ($E_1$, $E_2$, ... $E_M$) de la matrice de commutation; et
    - un bus de télémesure (BS) des N sorties ($S_1$, $S_2$, ...$S_N$) configuré pour mesurer chaque tension électrique ($VT_j$, $j \in [\![1; N]\!]$), appliquée entre la masse et une sortie DC de chaque T de polarisation ($T'_1$, $T'_2$, ... $T'_s$) disposé sur chaque sortie ($S_1$, $S_2$, ...$S_N$) de la matrice de commutation, le dispositif étant configuré pour déterminer l'état de chaque commutateur hyperfréquence (CT) à partir desdites mesures de tension électrique ($VT_j$, $j \in [\![1; N]\!]$), appliquée entre la masse et une sortie DC de chaque T de polarisation ($T'_1$, $T'_2$, ... $T'_s$) disposé sur chaque sortie ($S_1$, $S_2$, ...$S_N$).

2. Dispositif selon la revendication 1, dans lequel le ou les commutateurs hyperfréquence (CT) à contacts ohmiques montables en surface à au moins une entrée et au moins une position de sortie sont électromécaniques bistables.

3. Dispositif de commutation hyperfréquence selon la revendication 1 ou 2, dans lequel au moins un T de polarisation comprend un condensateur (C) et une bobine d'inductance (L).

4. Dispositif de commutation hyperfréquence selon l'une des revendications précédentes, dans lequel au moins un T de polarisation comprend deux condensateurs (C, $C_1$) et une bobine d'inductance (L).

5. Dispositif de commutation selon l'une des revendications précédentes, dans lequel un condensateur (C, $C_1$) de T de polarisation peut être remplacé par une ligne couplée (lc).

6. Dispositif de commutation selon l'une des revendications précédentes, dans lequel une bobine d'inductance (L) de T de polarisation peut être remplacée par une ligne quart d'onde ($^\lambda/_4$).

7. Dispositif de commutation hyperfréquence selon l'une des revendications précédentes, dans lequel :

- la matrice de commutation comprend un seul commutateur hyperfréquence (CT) à contacts ohmiques à une entrée et deux positions de sortie ou deux commutateurs à contacts ohmiques à une entrée et une position de sortie, montable en surface;
- le T de polarisation disposé sur l'entrée de la matrice de polarisation comprend un circuit LC d'entrée, comprenant une bobine d'inductance d'entrée (LE) et un condensateur d'entrée (CE), et connecté entre la bobine d'inductance d'entrée (LE) et le condensateur d'entrée (CE) à l'entrée (E) du commutateur hyperfréquence (CT), la tension électrique (VT) en sortie de la bobine d'inductance d'entrée (LE) étant représentative de l'état du commutateur hyperfréquence (CT);
- le T de polarisation disposé sur la première sortie de la matrice de polarisation comprend un premier circuit LC de sortie, comprenant une première bobine d'inductance de sortie (LS1) et un premier condensateur de sortie (CS1), connecté, entre la première bobine d'inductance de sortie (LS1) et le premier condensateur de sortie (CS1), à la première position de sortie (S1) du commutateur hyperfréquence (CT), et dont la première bobine d'inductance de sortie (LS1) est connectée, en son extrémité non reliée au premier condensateur de sortie (CS1), à une première référence (V1) de tension électrique;
- le T de polarisation disposé sur la deuxième sortie de la matrice de polarisation comprend un deuxième circuit LC de sortie, comprenant une deuxième bobine d'inductance de sortie (LS2) et un deuxième condensateur de sortie (CS2), connecté, entre la deuxième bobine d'inductance de sortie (LS2) et le deuxième condensateur de sortie (CS2), à la deuxième position de sortie (S2) du commutateur hyperfréquence (CT), et dont la deuxième bobine d'inductance de sortie (LS2) est connectée, en son extrémité non reliée au deuxième condensateur de sortie (CS2), à une deuxième référence (V2) de tension électrique;
- le bus de commande (BC) du commutateur hyperfréquence (CT) de la matrice de commutation (COM) comprend une première partie comprenant une première bobine d'inductance de commande (L1) disposée à proximité de la première position de sortie (S1), et une deuxième partie comprenant une deuxième bobine d'inductance de commande (L2) disposée à proximité de la deuxième position de sortie (S2), la première partie comprenant une première diode de commande (D1) disposée en parallèle de la première bobine d'inductance (L1) formant un ensemble connecté d'un côté à une référence

(V) de tension électrique de commande et connecté de l'autre côté à un premier interrupteur (I1) relié à la masse (M), et la deuxième partie comprenant une deuxième diode de commande (D2) disposée en parallèle de la deuxième bobine d'inductance (L2) formant un ensemble connecté d'un côté à la référence (V) de tension électrique de commande et connecté de l'autre côté à un deuxième interrupteur (I2) relié à la masse (M);

les capacités du condensateur d'entrée (CE), du premier condensateur de sortie (CS1) et du deuxième condensateur de sortie (CS2) étant identiques; et les inductances de la bobine d'inductance d'entrée (LE), de la première bobine d'inductance de sortie (LS1) et de la deuxième bobine d'inductance de sortie (LS2) étant identiques.

8. Dispositif de commutation selon l'une des revendications précédentes, dans lequel le ou les commutateurs hyperfréquence (CT) de la matrice de commutation (COM) sont à commande impulsionnelle.

9. Dispositif pour satellites comprenant un râtelier (RACK) et au moins une carte électronique adaptée pour être disposée dans le râtelier, la carte électronique comprenant au moins un dispositif de commutation selon l'une des revendications précédentes.

**Patentansprüche**

1. Hyperfrequenzschaltgerät, das Folgendes umfasst:

- eine Schaltmatrix (COM) mit M Eingängen ($E_1$, $E_2$, ...$E_M$) und N Ausgängen ($S_1$, $S_2$, ... $S_N$), die mindestens einen oberflächenmontierbaren Hyperfrequenzschalter (CT) mit ohmschen Kontakten umfasst, mit mindestens einem Eingang und mindestens einer Ausgangsposition und mindestens eine Schaltung zwischen mindestens einem der M Eingänge und mindestens einem der N Ausgänge der Schaltmatrix (COM) durchführen kann;
- einen Steuerbus (BC) des oder der Hyperfrequenzschalter(s) (CT) der Schaltmatrix (COM);
- ein Polarisations-T ($T_1$, $T_2$, ... $T_M$), das an jedem Eingang ($E_1$, $E_2$, ... $E_M$) der Schaltmatrix (COM) angeordnet ist
- ein Polarisations-T ($T'_1$, $T'_2$, ... $T'_s$), das an jedem Ausgang der Schaltmatrix angeordnet ist;

- einen Fernsteuerbus (BE) der M Eingänge ($E_1$, $E_2$, ...$E_M$), konfiguriert zum Steuern jeder zwischen einer Masse und einem Gleichstromeingang jedes Polarisations-T ($T_1$, $T_2$, ...$T_M$) anlie-

genden elektrischen Spannung ($VT_i$, $i \in [\![1; M]\!]$), angeordnet an jedem Eingang ($E_1$, $E_2$, ...$E_M$) der Schaltmatrix; und

- einen Telemetriebus (BS) der N Ausgänge ($S_1$, $S_2$, ...$S_N$), konfiguriert zum Messen jeder zwischen der Masse und einem Gleichstromausgang jedes Polarisations-T ($T'_1$, $T'_2$, ... $T'_s$) anliegenden elektrischen Spannung ($VT_j$, $j \in [\![1; N]\!]$), angeordnet an jedem Ausgang ($S_1$, $S_2$, ... $S_N$) der Schaltmatrix, wobei das Gerät konfiguriert ist zum Bestimmen des Zustands jedes Hyperfrequenzschalters (CT) auf der Basis der zwischen der Masse und einem Gleichstromausgang jedes Polarisations-T ($T'_1$, $T'_2$, ... $T'_s$) anliegenden elektrischen Spannungsmesswerten ($VT_i$, $j \in [\![1; N]\!]$), angeordnet an jedem Ausgang ($S_1$, $S_2$, ...$S_N$).

2. Gerät nach Anspruch 1, wobei der oder die oberflächenmontierbaren Hyperfrequenzschalter (CT) mit ohmschen Kontakten mit mindestens einem Eingang und mindestens einer Ausgangsposition bistabil elektromechanisch sind.

3. Hyperfrequenzschaltgerät nach Anspruch 1 oder 2, wobei mindestens ein Polarisations-T einen Kondensator (C) und einen Induktor (L) umfasst.

4. Hyperfrequenzschaltgerät nach einem der vorherigen Ansprüche, wobei mindestens ein Polarisations-T zwei Kondensatoren (C, $C_1$) und einen Induktor (L) umfasst.

5. Schaltgerät nach einem der vorherigen Ansprüche, wobei ein Polarisations-T-Kondensator (C, $C_1$) durch eine gekoppelte Leitung (lc) ersetzt werden kann.

6. Schaltgerät nach einem der vorherigen Ansprüche, wobei ein Polarisations-T-Induktor (L) durch eine Viertelwellenleitung ($\lambda/4$) ersetzt werden kann.

7. Hyperfrequenzschaltgerät nach einem der vorherigen Ansprüche, wobei:

   - die Schaltmatrix einen einzelnen oberflächenmontierbaren Hyperfrequenzschalter (CT) mit ohmschen Kontakten mit einem Eingang und zwei Ausgangspositionen oder zwei oberflächenmontierbare Schalter mit ohmschen Kontakten mit einem Eingang und einer Ausgangsposition umfasst;

- das am Eingang der Polarisationsmatrix angeordnete Polarisations-T eine Eingangsschaltung LC umfasst, die einen Eingangsinduktor (LE) und einen Eingangskondensator (CE) umfasst und zwischen dem Eingangsinduktor (LE) und dem Eingangskondensator (CE) am Eingang (E) des Hyperfrequenzschalters (CT) geschaltet ist, wobei die elektrische Spannung (VT) am Ausgang des Eingangsinduktors (LE) für den Zustand des Hyperfrequenzschalters (CT) repräsentativ ist;

- das am ersten Ausgang der Polarisationsmatrix angeordnete Polarisations-T eine erste Ausgangsschaltung LC umfasst, die einen ersten Ausgangsinduktor (LS1) und einen ersten Ausgangskondensator (CS1) umfasst und zwischen dem ersten Ausgangsinduktor (LS1) und dem ersten Ausgangskondensator (CS1) an der ersten Ausgangsposition (S1) des Hyperfrequenzschalters (CT) geschaltet ist und deren erster Ausgangsinduktor (LS1) am nicht mit dem ersten Ausgangskondensator (CS1) verbundenen Ende mit einer ersten elektrischen Spannungsreferenz (V1) verbunden ist;

- das am zweiten Ausgang der Polarisationsmatrix angeordnete Polarisations-T eine zweite Ausgangsschaltung LC umfasst, die einen zweiten Ausgangsinduktor (LS2) und einen zweiten Ausgangskondensator (CS2) umfasst und zwischen dem zweiten Ausgangsinduktor (LS2) und dem zweiten Ausgangskondensator (CS2) an der zweiten Ausgangsposition (S2) des Hyperfrequenzschalters (CT) geschaltet ist und deren zweiter Ausgangsinduktor (LS2) am nicht mit dem zweiten Ausgangskondensator (CS2) verbundenen Ende mit einer zweiten elektrischen Spannungsreferenz (V2) verbunden ist;

- der Steuerbus (BC) des Hyperfrequenzschalters (CT) der Schaltmatrix (COM) einen ersten Teil mit einem nahe der ersten Ausgangsposition (S1) angeordneten ersten Steuerinduktor (L1) und einen zweiten Teil mit einem nahe der zweiten Ausgangsposition (S2) angeordneten zweiten Steuerinduktor (L2) umfasst, wobei der erste Teil eine erste Steuerdiode (D1) umfasst, die parallel zum ersten Induktor (L1) angeordnet ist und eine Baugruppe bildet, die auf einer Seite mit einer Steuerspannungsreferenz (V) und auf der anderen Seite mit einem mit der Masse (M) verbundenen ersten Schalter (I1) verbunden ist, und der zweite Teil eine zweite Steuerdiode (D2) umfasst, die parallel zum zweiten Induktor (L2) angeordnet ist und eine Baugruppe bildet, die auf einer Seite mit der Steuerspannungsreferenz (V) verbunden ist und auf der anderen Seite mit einem mit der Masse (M) verbundenen zweiten Schalter (I2) verbunden ist;

wobei die Kapazitäten des Eingangskondensators (CE), des ersten Ausgangskondensators (CS1) und des zweiten Ausgangskondensators (CS2) identisch sind; und wobei die Induktivitäten des Eingangsinduktors (LE), des ersten Ausgangsinduktors (LS1) und des zweiten Ausgangsinduktors (LS2) identisch sind.

**8.** Schaltgerät nach einem der vorherigen Ansprüche, wobei der oder die Hyperfrequenzschalter (CT) der Schaltmatrix (COM) impulsgesteuert ist/sind.

**9.** Satellitengerät, das ein Gestell (RACK) und mindestens eine Leiterplatte zum Anordnen in dem Gestell umfasst, wobei die Leiterplatte mindestens ein Schaltgerät nach einem der vorherigen Ansprüche umfasst.

## Claims

**1.** Microwave switching device comprising:

- a switching matrix (COM) with M inputs ($E_1$, $E_2$, ...$E_M$) and N outputs ($S_1$, $S_2$, ...$S_N$) comprising at least one surface-mountable microwave switch (CT) with ohmic contacts with at least one input and at least one output position which is able to perform at least one switch between at least one of the M inputs and at least one of the N outputs of the switching matrix (COM);
- a control bus (BC) for the one or more microwave switches (CT) of the switching matrix (COM);
- a bias tee ($T_1$, $T_2$, ...$T_M$) positioned on each input ($E_1$, $E_2$, ...$E_M$) of the switching matrix (COM);
- a bias tee ($T'_1$, $T'_2$, ...$T'_S$) positioned on each output of the switching matrix;
- a remote-control bus (BE) for the M inputs ($E_1$, $E_2$, ... $E_M$) configured to control each voltage

($VT_i$, $i \in [\![1;M]\!]$) applied between ground and a DC input of each bias tee ($T_1$, $T_2$, ...$T_M$) positioned on each input ($E_1$, $E_2$, ... $E_M$) of the switching matrix; and

- a telemetry bus (BS) for the N outputs ($S_1$, $S_2$, ...$S_N$) configured to mesure each voltage

($VT_j$, $j \in [\![1;N]\!]$) applied between ground and a DC output of each bias tee ($T'_1$, $T'_2$, ...$T'_S$) positioned on each output ($S_1$, $S_2$, ...$S_N$) of the switching matrix, the device being configured to determine the state of each microwave switch (CT) from said voltage measures ($VT_j$,

$j \in [\![1;N]\!]$) applied between ground and a DC output of each bias tee ($T'_1$, $T'_2$, ...$T'_S$) positioned on each output ($S_1$, $S_2$, ...$S_N$).

**2.** Device according to claim 1, wherein the one or more surface-mountable microwave switches (CT) with ohmic contacts with at least one input and at least one output position are bistable electromechanical switches.

**3.** Microwave switching device according to claim 1 or 2, wherein at least one bias tee comprises one capacitor (C) and one inductance coil (L).

**4.** Microwave switching device according to one of the preceding claims, wherein at least one bias tee comprises two capacitors (C, $C_1$) and one inductance coil (L).

**5.** Switching device according to one of the preceding claims, wherein one bias tee capacitor (C, $C_1$) may be replaced with a coupled line (lc).

**6.** Switching device according to one of the preceding claims, wherein one bias tee inductance coil (L) may be replaced with a quarter-wave line ($^\lambda/_4$).

**7.** Microwave switching device according to one of the preceding claims, wherein:

- the switching matrix comprises a single surface-mountable microwave switch (CT) with ohmic contacts with one input and two output positions or two surface-mountable switches with ohmic contacts with one input and one output position;
- the bias tee positioned on the input of the bias matrix comprises an input LC circuit, comprising an input inductance coil (LE) and an input capacitor (CE), and connected between the input inductance coil (LE) and the input capacitor (CE) to the input (E) of the microwave switch (CT), the voltage (VT) at the output of the input inductance coil (LE) being representative of the state of the microwave switch (CT);
- the bias tee positioned on the first output of the bias matrix comprises a first output LC circuit, comprising a first output inductance coil (LS1) and a first output capacitor (CS1), which is connected, between the first output inductance coil (LS1) and the first output capacitor (CS1), to the first output position (S1) of the microwave switch (CT), and the first output inductance coil (LS1) of which is connected, at its end that is not linked to the first output capacitor (CS1), to a first voltage reference (VI);

- the bias tee positioned on the second output of the bias matrix comprises a second output LC circuit, comprising a second output inductance coil (LS2) and a second output capacitor (CS2), which is connected, between the second output inductance coil (LS2) and the second output capacitor (CS2), to the second output position (S2) of the microwave switch (CT), and the second output inductance coil (LS2) of which is connected, at its end that is not linked to the second output capacitor (CS2), to a second voltage reference (V2);

- the control bus (BC) for the microwave switch (CT) of the switching matrix (COM) comprises a first portion comprising a first control inductance coil (L1) that is positioned in proximity to the first output position (S1), and a second portion comprising a second control inductance coil (L2) that is positioned in proximity to the second output position (S2), the first portion comprising a first control diode (D1) that is positioned in parallel to the first inductance coil (L1), forming an assembly that is connected on one side to a control voltage reference (V) and connected on the other side to a first switch (I1) that is linked to ground (M), and the second portion comprising a second control diode (D2) that is positioned in parallel to the second inductance coil (L2), forming an assembly that is connected on one side to the control voltage reference (V) and connected on the other side to a second switch (12) that is linked to ground (M);

the capacitances of the input capacitor (CE), of the first output capacitor (CS1) and of the second output capacitor (CS2) being identical; and the inductances of the input inductance coil (LE), of the first output inductance coil (LS1) and of the second output inductance coil (LS2) being identical.

8. Switching device according to one of the preceding claims, wherein the one or more microwave switches (CT) of t switching matrix (COM) are pulse controlled.

9. Device for satellites comprising a rack (RACK) and at least one circuit board suitable for being positioned in the rack, the circuit board comprising at least one switching device according to one of the preceding claims.

FIG.1

FIG.2

FIG.3

FIG.4

FIG.5

FIG.6

FIG.7

FIG.8

FIG.9

BUS CAN

FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2004095205 A

**Littérature non-brevet citée dans la description**

- A High-Reliability High-Linearity High-Power RF MEMS Metal-Contact Switch for OC 40-GHz Applications. **CHIRAG D PATEL et al.** IEEE TRANSACTIONS ON MICROWAVE THEORY AND TECHNIQUES. PLENUM, 01 Octobre 2012, vol. 60, 3096-31 12